Europäisches Patentamt

European Patent Office

Office européen des brevets

(19)

(11) **EP 1 093 227 A1**

(12) **EUROPEAN PATENT APPLICATION**

(43) Date of publication:
**18.04.2001 Bulletin 2001/16**

(51) Int Cl.[7]: **H03L 7/08**, H03L 7/18

(21) Application number: **99402530.2**

(22) Date of filing: **14.10.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventor: **Oddoart, Ludovic**<br>**31270 Frouzins (FR)** |
| (71) Applicant: **MOTOROLA, INC.**<br>**Schaumburg, IL 60196 (US)** | (74) Representative: **Joly, Jean-Jacques et al**<br>**Cabinet Beau de Loménie**<br>**158, rue de l'Université**<br>**75340 Paris Cédex 07 (FR)** |

(54) **Digital phase-locked loop circuit**

(57)    A digital phase-locked loop circuit has a phase comparator arranged to compare phases of a received reference signal and feedback signal in order to provide a digital output signal. The circuit also includes a digital filter arranged to receive the digital output signal and to integrate the digital output signal to produce an integrated digital output signal. A digitally controlled oscillator is arranged to receive the integrated digital output signal and to generate an oscillating signal in dependence upon the integrated digital output signal. A divider is arranged to receive the oscillating signal and to provide the feedback signal to the phase comparator in dependence upon the oscillating signal. In this way the oscillating signal is substantially maintained at the frequency of the reference signal.

FIG. 1

EP 1 093 227 A1

Printed by Jouve, 75001 PARIS (FR)

**Description**

Field of the Invention

This invention relates to phase-locked loops and particularly but not exclusively to phase-locked loops used in portable communications equipment.

Background of the Invention

In mobile communications devices, and especially in cellular mobile communications devices, a large number of switched circuitry such as switched mode power supplies and Analogue to Digital converters are employed. Digital switching signals at particular frequencies are required to switch such circuitry, and therefore more and more clock signals at various frequencies must be generated in integrated circuits. These signals are typically provided by an analogue Phase-Locked Loop (PLL), which in turn requires an analogue filter.

There is strong desire to reduce the cost and size mobile communications devices, and one way to achieve this is to reduce the number of discrete components used in the device. Therefore there exists a need to implement the PLL and its filter without using discrete analogue components.

A known alternative to the use of discrete components is to implement the PLL using components integrated on a semiconductor integrated circuit. This also reduces the number of connection pins required for the integrated circuit.

However, a problem with this is the size and cost of the amount of semiconductor material required to implement analogue circuitry, especially when synthesising low frequencies (for example in the KHz range) where the time constant of the PLL requires a very large effective Resistor-Capacitor arrangement. A further problem is the process and temperature variations associated with semiconductor implementations of PLL's.

This invention seeks to provide a digital phase-locked loop which mitigates the above mentioned disadvantages.

Summary of the Invention

According to the present invention there is provided a digital phase locked loop as claimed in claim 1.

In this way a low cost, small PLL is provided without using discrete analogue components, using a small amount of semiconductor material, and with substantially no process and temperature variations.

Brief Description of the Drawings

An exemplary embodiment of the invention will now be described with reference to the drawings in which:

FIG. 1 shows a preferred embodiment of a phase-locked loop circuit in accordance with the invention;
FIG. 2 shows an alternative study model of the phase-locked loop circuit of FIG. 1;
FIG. 3 shows a graph illustrating the behaviour of the model of FIG. 2;
FIG. 4 shows a block schematic diagram of a digital controlled oscillator forming part of the phase-locked loop circuit of FIG. 1;
FIG. 5 shows a graph illustrating the behaviour of a phase comparator forming part of the phase-locked loop circuit of FIG. 1;
FIG. 6 shows a block schematic diagram of the phase comparator forming part of the phase-locked loop circuit of FIG. 1;
FIG. 7 shows block schematic diagram of a digital filter forming part of the phase-locked loop circuit of FIG. 1;
FIG. 8 shows an alternate embodiment of digital filter forming part of the phase-locked loop circuit of FIG. 1; and
FIG. 9 shows an alternate embodiment of the digital controlled oscillator forming part of the phase-locked loop circuit of FIG. 1;

Detailed Description of a Preferred Embodiment

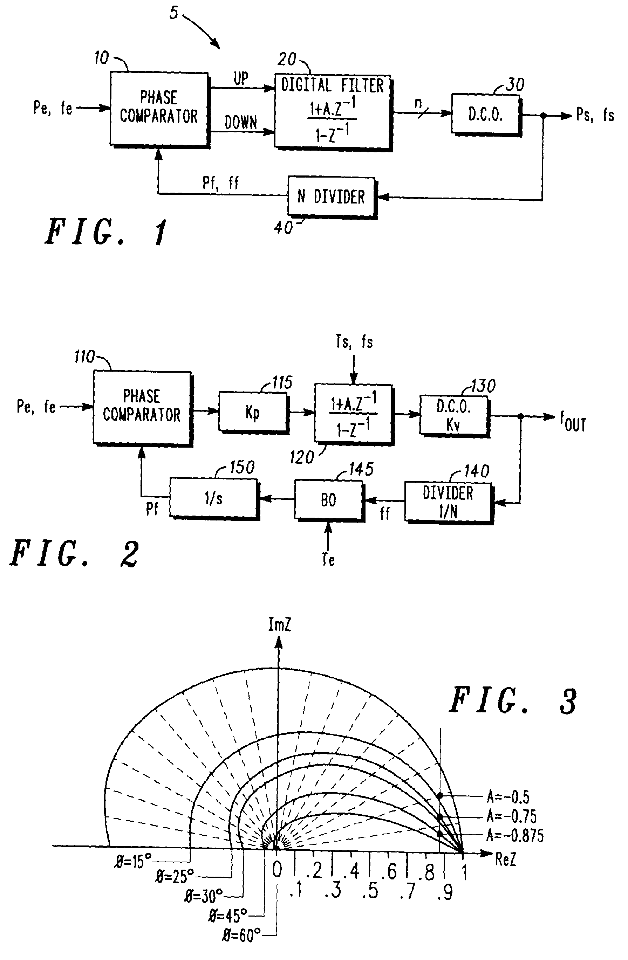

Referring to FIG. 1, there is shown a phase-locked loop circuit 5, having a phase comparator 10, a digital filter 20, a digitally controlled oscillator 30 and an 'N' divider 40.

The phase comparator 10 is arranged to receive a reference signal having a phase Pe and a frequency fe, and to compare this with a feedback signal to be further described below having a Phase Pf and a frequency ff. The result of this comparison is one of two output signals, an UP signal when Pf<Pe and a DW (Down) signal when Pf>Pe.

The digital filter 20 is arranged to receive the UP and DW signals and to perform an integration function in dependence thereon. A resulting bitstream of n bits is provided, to be further described below.

The digitally controlled oscillator 30 is arranged to receive the bitstream from the digital filter 20 in order to produce an output signal having a phase PS and a frequency fs. This is the output signal of the phase-locked loop circuit 5.

The 'N' divider 40 divides the output signal down to produce the feedback signal having phase Pf and frequency ff.

Referring now also to FIG. 2 there is shown an alternative study model of the PLL of FIG. 1, having a phase comparator 110, a digital filter 120, a digitally controlled oscillator 130 and an 'N' divider 140. Also included in the study model is a phase comparator gain block 115, a sample-and hold block 145 and an integrator block 150.

The phase comparator 110 is arranged to receive the reference signal having phase Pe and frequency fe, and to compare this with the feedback signal having phase Pf and frequency ff. The gain of the phase comparator is represented by:

$$Kp = \frac{fs}{2\pi fe} \qquad\qquad \text{Equation 1}$$

The digital filter 120 receives the output from the phase comparator gain block 115 and the output signal (Ts, fs, where Ts=1/fs). The digital filter 120 performs an integration according to the Z domain transfer function:

$$H(Z) = \frac{1 + (A.Z^{-1})}{1 - (Z^{-1})} \qquad\qquad \text{Equation 2}$$

The digitally controlled oscillator 130 is arranged to receive the bitstream from the digital filter 120. The gain of the digital controlled oscillator 130 is Kv, which is measured in Hz per step.

The 'N' divider 140 divides the output signal by N. to produce the feedback signal having phase Pf and frequency ff. This is passed to the sample and hold block 145, which performs a zero order (B0) sample and hold function using a period Te, (where Te=1/fe, the reference frequency from the oscillator). In this way a phase comparison is performed at the speed of fe, and the signal is converted from the Z domain to the s domain. Finally the integrator block 150 performs a frequency to phase transform (1/s).

Using equations 1 and 2, the Z transform of this arrangement is given by:

$$Z(B0 \; G(s)) = (1 - Z^{-1}).Z\left(\frac{G(s)}{s}\right) = (1 - Z^{-1}).Z\left(\frac{1}{s^2}\right) = (1 - Z^{-1}).Te\left(\frac{Z}{(Z-1)^2}\right)$$

$$Z(B0 \; G(s)) = \left(\frac{Te.Z^{-1}}{1 - Z^{-1}}\right) \qquad\qquad \text{Equation 3}$$

The object of the digital filter is to integrate the phase error. It is not possible to use a pure integrator for the digital filter because two integrations in the system will create an unstable loop (where there is no phase margin). Therefore, a digital 'zero' is added as per equation 2 above, to create a discrete pole/zero filter. The characteristic equation of the closed loop is therefore:

$$1 + \left(\frac{1 + A(Z^{-1})}{(1 - Z^{-1})}\right) Kp \; Kv \left(\frac{1}{N}\right)\left(\frac{Te \; Z^{-1}}{(1 - Z^{-1})}\right) = 0 \qquad\qquad \text{Equation 4}$$

$$Z^2 + Z\left(\frac{Kp\,Kv}{N\,fe} - 2\right) + \left(\frac{A\,Kp\,Kv}{N\,fe} + 1\right) = 0 \qquad \text{Equation 5}$$

$$Z^2 + Z\left(\frac{Kp\,Kv}{N\,fe} - 2\right) + \left(\frac{A\,Kp\,Kv}{N\,fe} + 1\right) = 0 \qquad \text{Equation 5}$$

Equations 4 and5 gives two poles Z1 and Z2 which directly correspond to poles s 1 and s2 from the following second order characteristic equations in the s domain:

$$s^2 + 2(\zeta\omega s) + \omega^2 = 0 \qquad \text{Equation 6}$$

$$p(1,2) = -\zeta\omega \mp j\omega\sqrt{1 - \zeta^2} \qquad \text{Equation 7}$$

Using equations 4, 5, 6 and 7, $\zeta$ and $\omega$ can be extracted. $\zeta$ is generally tuned between 0.707 (45 degrees of phase margin $\varphi$) and 0.866 (60 degrees of phase margin $\varphi$) to compromise stability and setup speed.

Referring now also to FIG. 3 there is shown a graph illustrating the behaviour of the model of FIG. 2, for various values of $\zeta$ in the Z domain. Knowing Z(1,2), $\zeta$ can be extracted.

Using this graph, the values of Kv and Kp can be adjusted (by changing the sampling frequency), and an appropriate digital zero constant A can be chosen, to achieve the desired stability.

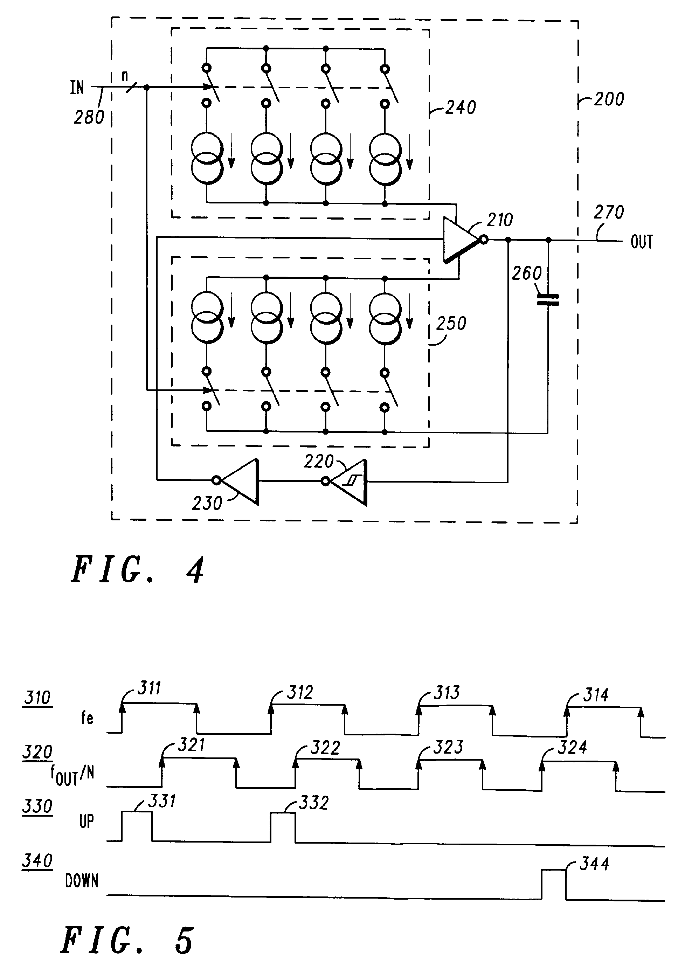

Referring now also to FIG. 4 there is shown a block schematic diagram 200 of the digital controlled oscillator 30 of FIG. 1. The digital oscillator has a ring oscillator structure, and is constituted by an odd number of inverters. A first inverter 210 has an output coupled to the input of a second inverter 220 which is in the form of a schmitt trigger. The second inverter 220 has an output coupled to the input of a third inverter 230, which similarly has an output coupled to the input of the first inverter 210. The output of the first inverter 210 is also coupled to provide an output to an output terminal 270. The schmitt trigger arrangement of the second inverter is necessary to ensure that the ring oscillator functions correctly at startup.

Two banks of reference current sources 240 and 250 provide a bias current to the first inverter 210. The bias current is dependent upon the digital signal received from the digital filter 20 at an input terminal 280 of the digital controlled oscillator 30. The bias current charges and discharges a capacitor 260 from the low to the high threshold of the schmitt trigger. In this way, an output frequency is created at the output terminal 270 which is proportional to the digital signal received at the input terminal 280.

Referring now also to FIG. 5, there is shown a graph illustrating the behaviour of the phase comparator 10 of FIG. 1. A first line 310 represents fe, a second line 320 represents fout/N, a third line 330 represents the UP signal and a fourth line 340 represents the DW (Down) signal.

The first line 310 has a number of positive edges 311, 312, 313, 314... Similarly the second line 320 has a number of positive edges 321, 322, 323, 324...

The positive edge 311 of the first line310 occurs before the positive edge 321 of the second line 320. Therefore the desired signal is an UP signal 331, the duration of which is determined by the period between these positive edges. Similarly the positive edge 312 of the first line310 occurs before the positive edge 322 of the second line 320. Therefore the desired signal is an UP signal 332, the duration of which is determined by the period between these positive edges (less than that between 311 and 321).

The positive edges 313 and 323 are coincident, and therefore no UP or DW signal should be produced. Finally the positive edge 314 of the first line310 occurs after the positive edge 324 of the second line 320. Therefore the desired signal is an DW signal 344, the duration of which is determined by the period between these positive edges.

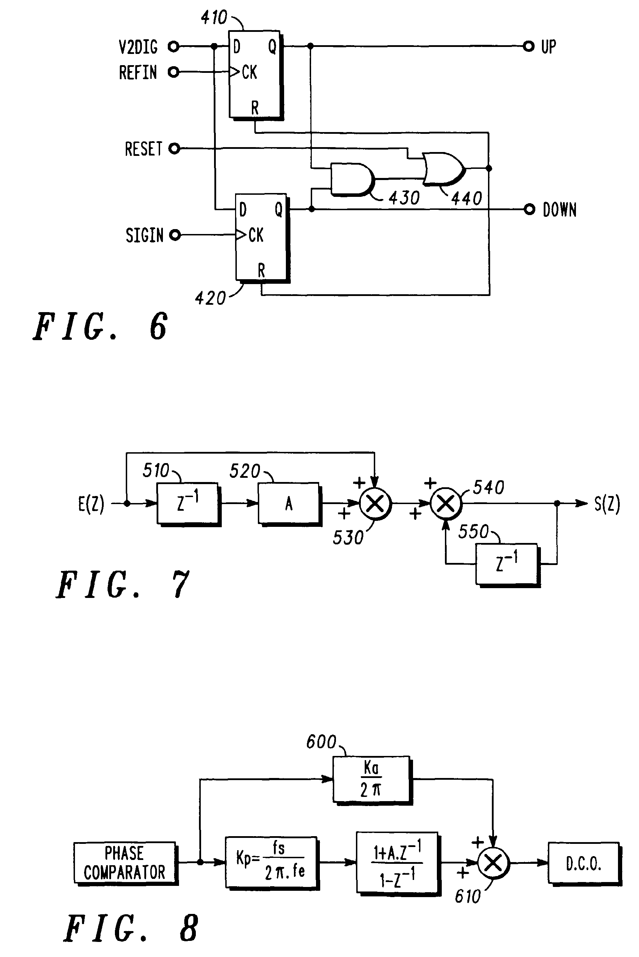

FIG. 6 shows a block schematic diagram of the phase comparator 10, such that the required UP and DW signals referred to in FIG. 5 are produced. The phase comparator 10 has a first D-type flip flop 410 coupled to receive the reference signal from the oscillator (not shown) for providing a first clocked output, and a second D-type flip flop 420 coupled to receive the feedback signal from the N divider 40 for providing a second clocked output. The first and second clocked outputs provide two inputs to an AND gate 430, which has an AND output. An OR gate 440 has one input coupled to the AND output, another input coupled to a reset line, and an output coupled to reset inputs of the first and second D-type flip-flops 410 and 420. The reset line is used at startup to reset the first and second D-type flip-flops 410 and 420.

In this way the rising edge of either the reference signal or the feedback signal sets one of the first and second D-type flip-flops 410 and 420, and the rising edge of the other of the reference signal and feedback signal sets the other flip-flop, this creating positive outputs at the AND gate 430 and OR gate 440, which resets both first and second D-type flip-flops 410 and 420.

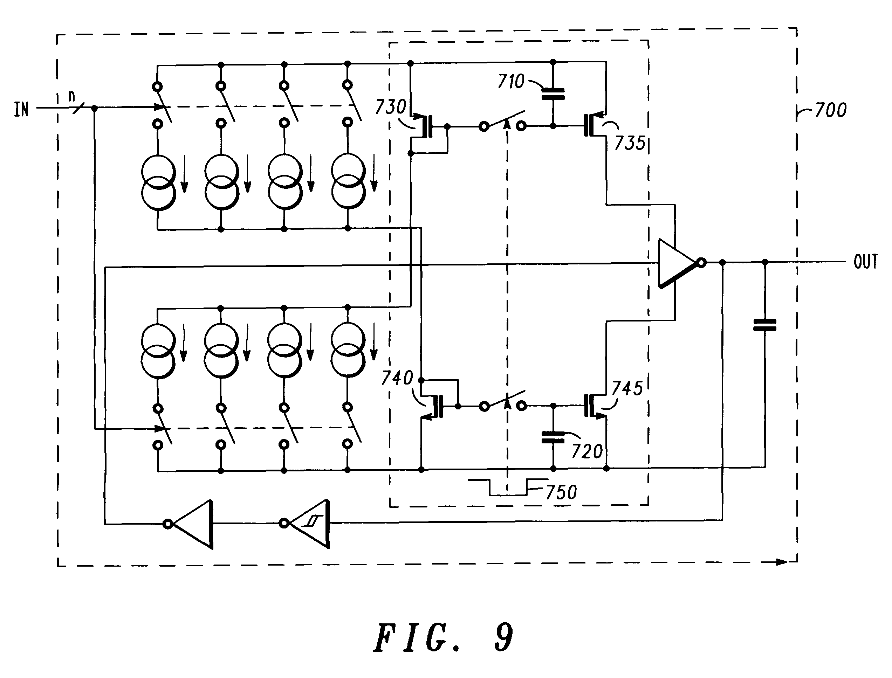

Referring now also to FIG. 7 there is shown a illustrative block diagram, in the Z domain, of the digital filter 20 of FIG. 1. $AZ^{-1}$ block 510 has an input coupled to receive $E(Z)$ and an output coupled to the input of an A block 520. The output of the A block 520 provides the first input of a first summation block 530. A second input of the first summation block 530 is coupled to receive $E(Z)$. In this way the $Z^{-1}$ block 510, the A block 520 and the first summation block 530 provide the transfer function "$1-AZ^{-1}$".

An output of the first summation block 530 is coupled to a first input of a second summation block 540. An output of the second summation block 540 is an output $S(Z)$.

A further $Z^{-1}$ block 550 has an input coupled to $S(Z)$ and an output coupled to a second input of the second summation block 540. In this way the second summation block 540 and the further $Z^{-1}$ block 550 provide the transfer function "$1/(1-Z^{-1})$".

This provides a filter which satisfies equation 2 above. Rewritten, equation 2 can be expressed as:-

$$\frac{S(Z)}{E(Z)} = \frac{1+(A.Z^{-1})}{1-(Z^{-1})} \qquad \text{Equation 8}$$

which leads to the equation:

$$S(Z) = Z^{-1}S(Z) + E(Z) + AZ^{-1}E(Z) \text{ in the Z domain} \qquad \text{Equation 9}$$

which becomes:

$$S(nT) = S(n-1)T + E(nT) + A\,E(n-1)T \text{ in the time domain} \qquad \text{Equation 10}$$

In this way a phase-locked loop arrangement is provided using the digital filter 20 and digitally controlled oscillator 30, together with the phase comparator 10 and N divider 40.

In some cases, it may be difficult to select an appropriate A factor which will facilitate a stable loop. Referring now also to FIG. 8 there is shown an alternate embodiment of the digital filter 10 of FIG. 1. In this alternative embodiment, a ratio of the output of the phase comparator 10 is directly added to the digitally controlled oscillator 30 via the block 600 (ka/2π) and summation block 610. The transfer function of this configuration is given by:

$$C(Z) = Ka + Kp + \left(\frac{1 + A(Z^{-1})}{(1 - Z^{-1})}\right) = \left(\frac{Ka + Kp}{(1 - Z^{-1})}\right)\left(1 + Z^{-1}\left(\frac{Kp\,A - Ka}{Ka + Kp}\right)\right) = 0 \quad \text{Equation 11}$$

Equation 11 represents a strongly stable loop.

Finally, referring now also to FIG. 9, there is shown an alternate embodiment of the digital controlled oscillator 30. This alternate embodiment is more complex than that shown in FIG. 4; however, it addresses the problem of transient frequency spikes, by using a switched capacitor arrangement 700. Two capacitors 710 and 720 respectively, are switched by transistor mirrors 730, 735 and 740, 745 respectively according to a sampling clock 750. The banks of reference sources are used to drive the mirrors. (Ludovic please explain a little further how this works).

It will be appreciated that alternative embodiments to the one described above are possible. For example, the precise arrangement of the circuitry described above may be varied from that shown. Furthermore, the number of inverters and reference sources shown in the digital controlled oscillator may differ from than shown.

**Claims**

1. A digital phase-locked loop circuit, comprising :

   a phase comparator (10 ; 110), arranged to compare phases of a received reference signal and feedback signal, for providing a digital output signal;
   a digital filter (20 ; 120) coupled to receive the digital output signal and arranged to integrate the digital output signal in order to produce an integrated digital output signal ;
   a digitally controlled oscillator (30 ;130) coupled to receive the integrated digital output signal and arranged for generating an oscillating signal in dependence upon the integrated digital output signal ; and
   a divider (40 ;140) coupled to receive the oscillating signal and arranged for providing the feedback signal in dependence thereon ;

   wherein the oscillating signal is substantially maintained at the frequency of the reference signal.

2. The circuit of claim 1 wherein the digital filter is further arranged to add a digital 'zero' to the digital outpt signal in order to prevent the circuit from becoming unstable.

3. The circuit of claim 1 or claim 2 wherein the digitally controlled oscillator comprises a ring oscillator having an odd number of inverters (210 , 220 , 230)

4. The circuit of claim 3 wherein one (220) of the number of inverters is a schmitt trigger.

5. The circuit of claim 3 or claim 4 wherein the digitally controlled oscillator further comprises a plurality of reference current sources (240, 250) arranged to provide a bias current to one of the number of inverters.

6. The circuit of any one of claims 3,4 or 5 wherein the digitally controlled oscillator further comprises a switched capacitor arrangement (260) coupled to the ring oscillator for reducing the effects of transient current.

7. The circuit of any preceding claim wherein the phase comparator comprises two D-type flip-flops (410,420) having clocked outputs coupled to two inputs of an AND gate (430).

FIG. 1

FIG. 2

FIG. 3

*FIG. 4*

*FIG. 5*

*410*

V2DIG ○——————•——| D      Q |——————•———————————————————○ UP

REFIN ○—————————|>CK      |

                |        |
                |   R    |

RESET ○—————————————————————————————————————————————————————————

                |        |
           ○————| D      Q |——•——⟫AND 430⟫——⟫OR 440⟩——•——————○ DOWN

SIGIN ○—————————|>CK      |

                |   R    |
*420*

# FIG. 6

*510*          *520*

E(Z) ——•——→| Z⁻¹ |——→| A |——→(+)(×)——→(+)(×)———•——→ S(Z)
$$E(Z) \rightarrow \boxed{Z^{-1}} \rightarrow \boxed{A} \rightarrow \otimes \rightarrow \otimes \rightarrow S(Z)$$

*530*          *540*

*550*  $\boxed{Z^{-1}}$

# FIG. 7

*600*  $\boxed{\dfrac{Ka}{2\pi}}$

$$\boxed{\text{PHASE COMPARATOR}} \rightarrow \boxed{Kp = \dfrac{fs}{2\pi \cdot fe}} \rightarrow \boxed{\dfrac{1 + A.Z^{-1}}{1 - Z^{-1}}} \rightarrow \otimes \rightarrow \boxed{\text{D.C.O.}}$$

*610*

# FIG. 8

*FIG. 9*

**European Patent Office**

**EUROPEAN SEARCH REPORT**

Application Number

EP 99 40 2530

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 739 725 A (FERRAIOLO FRANK DAVID ET AL) 14 April 1998 (1998-04-14)<br>* column 1, line 26 - line 43 *<br>* column 2, line 13 - column 5, line 56 *<br>* figures 1-5 * | 1-3,5-7 | H03L7/08<br>H03L7/18 |
| Y | | 4 | |
| Y | JEONG D -K ET AL: "DESIGN OF PLL-BASED CLOCK GENERATION CIRCUITS"<br>IEEE JOURNAL OF SOLID-STATE CIRCUITS,US,IEEE INC. NEW YORK,<br>vol. SC-22, no. 2,<br>1 April 1987 (1987-04-01), pages 255-261,<br>XP002027247<br>ISSN: 0018-9200<br>* page 256, column 2, line 9 - page 257, column 1, line 10; figures 2,3C,4 * | 4 | |
| X | US 5 727 038 A (MAY MICHAEL R ET AL) 10 March 1998 (1998-03-10)<br>* column 2, line 9 - column 12, line 6; figures * | 1-3,7 | |
| Y | | 4 | TECHNICAL FIELDS SEARCHED (Int.Cl.7)<br><br>H03L<br>H03K |
| X | EP 0 528 283 A (SONY CORP) 24 February 1993 (1993-02-24)<br>* column 4, line 4 - column 5, line 55; figures 1-4 * | 1,3,7 | |
| Y | | 4 | |
| X | DE 27 35 053 A (SIEMENS AG) 8 February 1979 (1979-02-08)<br>* page 4, line 6 - page 12, line 9; figures * | 1,2 | |

-/--

The present search report has been drawn up for all claims

| Place of search | Date of completion of the search | Examiner |
|---|---|---|
| THE HAGUE | 16 March 2000 | Balbinot, H |

EPO FORM 1503 03.82 (P04C01)

## EUROPEAN SEARCH REPORT

**European Patent Office**

**Application Number**

EP 99 40 2530

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 909 030 A (ST MICROELECTRONICS SRL) 14 April 1999 (1999-04-14) * column 6, line 8 - column 7, line 45; figure 3 * | 6 | |
| A | US 5 550 515 A (LIANG JUI ET AL) 27 August 1996 (1996-08-27) * column 5, line 10 - column 7, line 25; figures 4-6 * | 7 | |

TECHNICAL FIELDS SEARCHED (Int.Cl.7)

The present search report has been drawn up for all claims

| Place of search | Date of completion of the search | Examiner |
|---|---|---|
| THE HAGUE | 16 March 2000 | Balbinot, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 99 40 2530

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2000

| Patent document cited in search report | | Publication date | Patent family member(s) | | Publication date |
|---|---|---|---|---|---|
| US 5739725 | A | 14-04-1998 | NONE | | |
| US 5727038 | A | 10-03-1998 | NONE | | |
| EP 0528283 | A | 24-02-1993 | JP | 5048446 A | 26-02-1993 |
| | | | DE | 69229087 D | 10-06-1999 |
| | | | DE | 69229087 T | 11-11-1999 |
| | | | US | 5329254 A | 12-07-1994 |
| DE 2735053 | A | 08-02-1979 | NONE | | |
| EP 0909030 | A | 14-04-1999 | NONE | | |
| US 5550515 | A | 27-08-1996 | NONE | | |

EPO FORM P0459

For more details about this annex : see Official Journal of the European Patent Office, No. 12/82